# EUROPEAN PATENT APPLICATION

(11) **EP 4 697 922 A1**
(43) Date of publication of application: **18.02.2026**
(21) Application number: 25192153.2
(22) Date of filing: 28.07.2025
(51) Int. Cl.: H10P 74/00

(54) **INTEGRATED CIRCUIT INCLUDING BACKSIDE WIRING AND METHOD OF DESIGNING THE SAME**

(30) Priority: 05.08.2024 KR 20240104127
(71) Applicant: Samsung Electronics Co., Ltd., Suwon-si, Gyeonggi-do 16677 (KR)
(72) Inventor: YU, Jisu, 16677 Suwon-si (KR); YANG, Jaewan, 16677 Suwon-si (KR); KIM, Wootae, 16677 Suwon-si (KR); KIM, Jaehoon, 16677 Suwon-si (KR); KIM, Juyeon, 16677 Suwon-si (KR)
(74) Representative: Marks & Clerk LLP

(57) **Abstract**

An example integrated circuit includes a plurality of cells positioned in a plurality of rows extending in a first horizontal direction. The plurality of cells include a first cell disposed in a first row. The first cell comprises a first active pattern extending in the first horizontal direction and a first backside pattern overlapping the first active pattern in a vertical direction and extending in the first horizontal direction in a first backside wiring layer below the first active pattern. The first backside pattern is removed from a first inspection region that overlaps the first active pattern and extends in a second horizontal direction.

## Description

### BACKGROUND

Integrated circuits manufactured through semiconductor processes may include defects due to various factors. An integrated circuit including a defect may not have the designed performance, may not perform the designed function, or may have a shortened lifespan. A semiconductor process may include a process of inspecting integrated circuits to detect defects. As the size of the devices included in integrated circuits decreases and structures thereof become more complex, the difficulty of the process of inspecting integrated circuits may also increase.

### SUMMARY

The present disclosure relates to an integrated circuit including backside wiring and a structure that allows easy inspection and a method of designing the same.

In some implementations, an integrated circuit includes a plurality of cells arranged in rows extending in a first horizontal direction, wherein the plurality of cells include a first cell disposed in a first row, wherein the first cell comprises a first active pattern extending in the first horizontal direction and a first backside pattern overlapping the first active pattern in the vertical direction and extending in the first horizontal direction in a first backside wiring layer below the first active pattern, wherein the first backside pattern is removed from a first inspection region that overlaps the first active pattern and extends in a second horizontal direction.

In some implementations, an integrated circuit includes a plurality of cells arranged in rows extending in a first horizontal direction, wherein the plurality of cells include a first cell disposed in a first row, wherein the first cell comprises a first active pattern extending in the first horizontal direction and a first backside pattern overlapping the first active pattern in the vertical direction and extending in the first horizontal direction in a first backside wiring layer below the first active pattern, wherein the first backside pattern is excluded from (e.g. is not positioned within) a first inspection region that overlaps the first active pattern and extends in a second horizontal direction.

In some implementations, an integrated circuit includes a plurality of active patterns extending in a first horizontal direction and a plurality of backside patterns extending below the plurality of active patterns, wherein the plurality of backside patterns include a first backside pattern overlapping a first active pattern among the plurality of active patterns in a vertical direction and extending in a first backside wiring layer in the first horizontal direction, wherein the first backside pattern is removed from a first inspection region that overlaps the first active pattern and extends in a second horizontal direction.

In some implementations, a method of designing an integrated circuit includes obtaining input data defining a plurality of cells included in the integrated circuit, placing the plurality of cells based on a cell library, and generating output data defining the plurality of placed cells, wherein the cell library defines a first layout and a second layout of a first cell among the plurality of cells, and the placing of the plurality of cells includes disposing the first layout and replacing the first layout with the second layout, wherein the first layout includes a first backside pattern extending continuously in the first backside wiring layer in a first horizontal direction from a first boundary to a second boundary of the first layout, and the second layout includes a second backside pattern corresponding to the first backside pattern from which a portion is removed from the first inspection region.

Implementations refer to one or more inspection regions in which one or more backside wiring layers have been "removed". The term "removed" may be interpreted to mean that the one or more backside wiring layers are not present (e.g. are excluded) from the one or more inspection regions. That is, the term "removed" does not necessarily imply that the one or more backside wiring layers were previously present in the device in the one or more inspection regions (e.g. during manufacture), but have been etched or otherwise cut away from the one or more inspection regions (e.g. during manufacture). Instead, the one or more backside wiring layers may be arranged in the device such that they are not formed (e.g. never formed) within the one or more inspection regions.

Conductive patterns (e.g. backside patterns) that are arranged in the same wiring layer (e.g. the first backside wiring layer) may overlap each other in a horizontal direction (e.g. a direction parallel to an upper side and/or lower side of the substate), such as the first direction. The term "overlap in a direction" may refer to two elements that are arranged such that a straight line that runs parallel to the direction can be defined such that is passes through at least a portion of each of the two elements. For instance, two elements that "vertically overlap" each other may be arranged such that a straight line can be defined that runs perpendicular to an upper surface and/or lower surface of a substrate and passes through at least a portion of each of the two elements. Conductive patterns (e.g. backside patterns) that are arranged in the same wiring layer (e.g. the first wiring layer) may be arranged at the same vertical height (e.g. the same position along a vertical direction relative to the upper surface and/or lower surface of the substrate). A vertical direction may be a direction perpendicular to the upper surface and/or lower surface of the substrate.

At least some of the above and other features of the invention are set out in the claims.

### BRIEF DESCRIPTION OF THE DRAWINGS

Implementations are more clearly understood from the following detailed description taken in conjunction with the accompanying drawings.
FIG. 1 is a diagram illustrating an example of a layout of an integrated circuit.
FIGS. 2A, 2B, 2C, and 2D are drawings illustrating examples of devices.
FIG. 3 is a diagram illustrating an example of a layout of an integrated circuit.
FIGS. 4A, 4B, and 4C are drawings illustrating an example of a layout of an integrated circuit.
FIGS. 5A and 5B are drawings illustrating examples of layouts of integrated circuits.
FIGS. 6A and 6B are drawings illustrating examples of layouts of integrated circuits.
FIGS. 7A and 7B are drawings illustrating examples of layouts of integrated circuits.
FIG. 8 is a diagram illustrating an example of a layout of an integrated circuit.
FIGS. 9A and 9B are drawings illustrating examples of layouts of integrated circuits.
FIG. 10 is a flowchart illustrating an example of a method of manufacturing an integrated circuit.
FIG. 11 is a flowchart illustrating an example of a method of designing an integrated circuit.
FIG. 12 is a flowchart illustrating an example of a method of designing an integrated circuit.
FIG. 13 is a block diagram illustrating an example of a system-on-chip.
FIG. 14 is a block diagram illustrating an example of a computing system including a memory storing a program.

### DETAILED DESCRIPTION

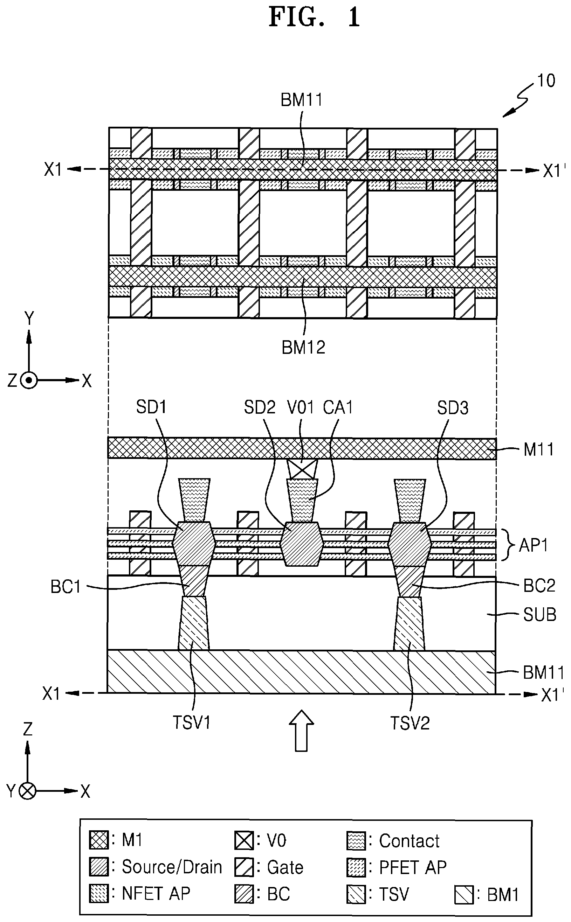

FIG. 1 is a diagram illustrating an example of a layout 10 of an integrated circuit. FIG. 1 illustrates a plan view of the layout 10 and a cross-sectional view of the layout 10 taken along line X1-X1'.

Herein, the X-axis direction and the Y-axis direction may be referred to as a first direction and a second direction, respectively, and the Z-axis direction may be referred to as a vertical direction or a third direction. A plane formed by the X-axis and the Y-axis may be referred to as a horizontal plane, and a component located in the +Z direction relative to other components may be referred to as being above other components, and a component located in the -Z direction relative to other components may be referred to as being below other components. The X-axis direction may be parallel to a substrate (e.g. to an upper surface and/or a lower surface of a substrate). The Y-axis direction may be parallel to the substrate (e.g. to the upper surface and/or lower surface of the substrate). The Z-axis direction may be perpendicular to the substrate (e.g. to the upper surface and/or lower surface of the substrate). The X-axis direction may cross (e.g. may be perpendicular to) the Y-axis direction. In addition, the area of a component may refer to the size of the component occupying in a plane parallel to the horizontal plane, and the width of a component may refer to the length in a direction orthogonal to the direction in which the component extends. A surface exposed in the +Z direction may be referred to as an upper surface, a surface exposed in the -Z direction may be referred to as a bottom surface, and a surface exposed in the ±X direction or ±Y direction may be referred to as a side surface. It will be appreciated that these relative positions and directions are defined relative to the structure of the device, and need not imply any particular orientation of the device in use. In the drawings herein, only some layers may be shown for convenience of illustration, and vias connecting upper and lower patterns may be indicated for understanding even though the vias are located below the upper pattern. In addition, a pattern including a conductive material, such as a pattern of a wiring layer, may be referred to as a conductive pattern or may simply be referred to as a pattern.

As used herein, the singular forms "a", "an", and "the" are intended to include the plural forms as well, unless the context clearly indicates otherwise. Additionally, the description may be specific to a portion of the device and the described structure may be repeated in other portions of the device. For example, the described structure may be an individual element of an array of elements forming the device. Accordingly, where the structure of a single element of a plurality of elements has been described, this structure may equally apply to other elements of the plurality of elements.

The terms "first", "second", third" may be used to describe various elements but the elements are not limited by the terms and a "first element" may be referred to as a "second element". Alternatively or additionally, the terms "first", "second", "third", etc. may be used to distinguish components from each other and do not limit the present disclosure. For example, the terms "first", "second", "third", etc. may not necessarily involve an order or a numerical meaning of any form.

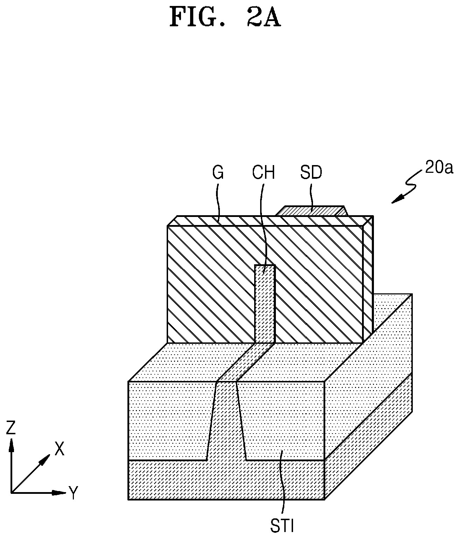

The integrated circuit may include devices, such as transistors, arranged on a substrate SUB. The devices may be arranged on an upper surface (otherwise known as a front side) of the substrate SUB. Examples of devices arranged on the substrate SUB are described below with reference to FIGS. 2A to 2D. The integrated circuit may include patterns extending over the devices (e.g. on the upper surface of the substrate SUB) as well as patterns extending below the substrate SUB (e.g. on a lower surface, otherwise known as a back side, of the substrate SUB). For example, as illustrated in FIG. 1, the layout 10 may include patterns extending in a frontside wiring layer above the substrate SUB, such as a first frontside wiring layer M1, as well as patterns extending in a backside wiring layer below the substrate SUB, such as a first backside wiring layer BM1. Herein, the pattern of the frontside wiring layer may be referred to as a frontside pattern, and the pattern of the backside wiring layer may be referred to as a backside pattern. In some implementations, the backside patterns may be used to supply power to the devices, and the backside patterns used to supply power to the devices may be referred to as a backside power delivery network. Due to the backside patterns, routing resources in the frontside wiring layers may increase, and the integrated circuit may have a reduced area and/or an efficient structure. In particular, when the backside patterns are used for power supply, a supply voltage that is provided to the devices may not be lowered (or may be lowered less) due to reduced IR drop.

Referring to FIG. 1, the layout 10 may include gates (or gate electrodes) extending in the Y-axis direction and active patterns extending in the X-axis direction. For example, as illustrated in FIG. 1, p-channel field effect transistor (PFET) active patterns and n-channel field effect transistor (NFET) active patterns may extend in the X-axis direction and intersect the gates extending in the Y-axis direction. A source/drain may be formed on each side of the gate, and a channel may be formed between the source/drains. In some implementations, the source/drain may be referred to as a diffusion region.

A first backside pattern BM11 and a second backside pattern BM12 may extend in the X-axis direction in the first backside wiring layer BM1, and a backside interlayer dielectric (BILD) may be inserted between the first backside pattern BM11 and the second backside pattern BM12. In some implementations, the first backside pattern BM11 may provide a positive supply voltage to the PFET and may extend in the X-direction below the PFET active pattern, as illustrated in FIG. 1. In some implementations, the second backside pattern BM12 may provide a negative supply voltage to the NFET and may extend in the X-direction below the NFET active pattern, as illustrated in FIG. 1.

The layout 10 may include a through-silicon via TSV penetrating through the substrate SUB and a backside contact BC connected to a lower surface of the source/drain. For example, as illustrated in FIG. 1, a first through-silicon via TSV1 and a second through-silicon via TSV2 may extend from an upper surface of the first backside pattern BM11. A first backside contact BC1 may be disposed on a first through-silicon via TSV1 and may be connected to a first source/drain SD1. In addition, a second backside contact BC2 may be disposed on the second through-silicon via TSV2 and may be connected to a third source/drain SD3. In some implementations, unlike that illustrated in FIG. 1, the through-silicon via may be omitted and the backside contact may extend from the backside pattern to the source/drain. When a positive supply voltage is applied to the first backside pattern BM11, the first source/drain SD1 and the third source/drain SD3 may receive a positive supply voltage from the first backside pattern BM11. As illustrated in FIG. 1, the first frontside pattern M11 may be connected to a second source/drain SD2 through a first via V01 of a first via layer V0 and a first contact (or a first source/drain contact) CA1.

Integrated circuits may be manufactured using semiconductor processes and may include defects due to various factors. Physical failure analysis (PFA) may refer to analyzing defects in integrated circuits using analysis equipment. For example, optical fault isolation (OFI) may refer to the use of various optical techniques, such as photo-emission and static laser stimulation, to detect defects in integrated circuits. As shown by the arrows in FIG. 1, when a laser is irradiated from the bottom to the top, i.e., in a +Z-axis direction, for OFI, the laser may be blocked by the patterns of the backside wiring layer and may not reach a location to be inspected. For example, as illustrated in FIG. 1, when the first backside pattern BM11 is disposed below a PFET active pattern AP1, the laser may not reach the PFET active pattern AP1 and it may be difficult to inspect a junction of the transistor.

As described below with reference to the drawings, the integrated circuit may include a structure that provides for easy inspection. Accordingly, integrated circuits including a backside wiring may be inspected and defects may be easily detected. In addition, integrated circuits including defects may be easily excluded, thereby ensuring shipment of integrated circuits providing the designed performance and functions.

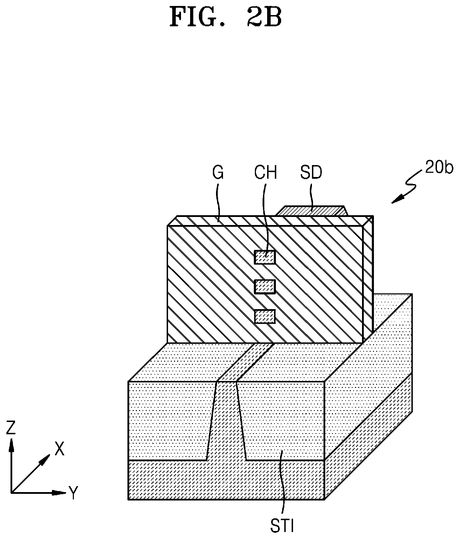

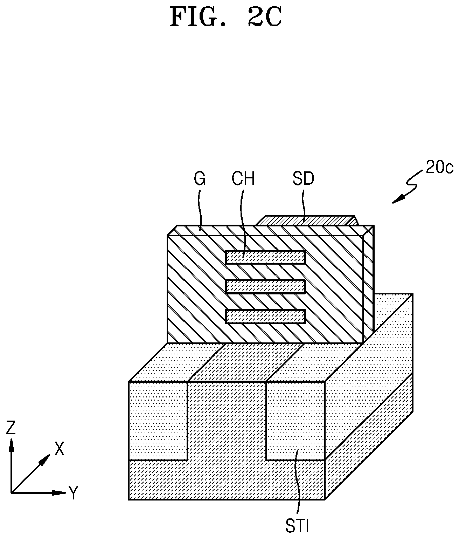

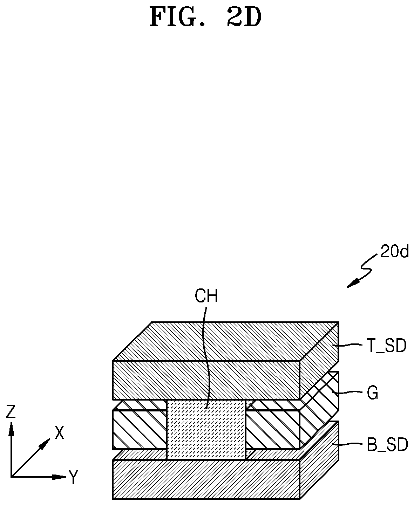

FIGS. 2A, 2B, 2C, and 2D are drawings illustrating examples of devices. For example, FIG. 2A illustrates a FinFET 20a, FIG. 2B illustrates a gate-all-around field effect transistor (GAAFET) 20b, FIG. 2C illustrates a multi-bridge channel field effect transistor (MBCFET) 20c, and FIG. 2D illustrates a vertical field effect transistor (VFET) 20d. For convenience of illustration, FIGS. 2A to 2C illustrate a state in which one of the two source/drain regions is removed, and FIG. 2D illustrates a cross-section of the VFET 20d cut along a plane parallel to the Y-axis and the Z-axis and passing through a channel CH of the VFET 20d.

Referring to FIG. 2A, the FinFET 20a may be formed by a fin-shaped active pattern extending in the Y-axis direction between shallow trench isolations (STIs) and a gate G extending in the Y-axis direction. A source/drain SD may be formed on both sides of the gate G, and accordingly, a source and a drain may be apart from each other in the X-axis direction. An insulating film may be formed between the channel CH and the gate G. In some implementations, the FinFET 20a may be formed by a plurality of active patterns and the gate G apart from each other in the X-axis direction.

Referring to FIG. 2B, the GAAFET 20b may be formed by active patterns, i.e., nanowires, extending in the X-axis direction and being apart from each other in the Z-axis direction and the gate G extending in the Y-axis direction. The source/drain SD may be formed on both sides of the gate G, and accordingly, the source and drain may be apart from each other in the X-axis direction. An insulating film may be formed between the channel CH and the gate G. It is noted that the number of nanowires included in GAAFET 20b is not limited to that shown in FIG. 2B.

Referring to FIG. 2C, the MBCFET 20c may be formed by active patterns, i.e., nanosheets, extending in the X-axis direction and being apart from each other in the Z-axis direction and the gate G extending in the Y-axis direction. A source/drain SD may be formed on both sides of the gate G, and thus the source and drain may be apart from each other in the X-axis direction. An insulating film may be formed between the channel CH and the gate G. It is noted that the number of nanosheets included in MBCFET 20c is not limited to that shown in FIG. 2C.

Referring to FIG. 2D, the VFET 20d may include a top source/drain T_SD and a bottom source/drain B_SD apart from each other in the Z-axis direction with the channel CH therebetween. The VFET 20d may include the gate G surrounding the channel CH between an upper source/drain T_SD and a lower source/drain B_SD. An insulating film may be formed between the channel CH and the gate G.

Hereinafter, the integrated circuit including the FinFET 20a or the MBCFET 20c is mainly described, but it is noted that the devices included in the integrated circuit are not limited to the examples of FIGS. 2A to 2D. For example, the integrated circuit may include a ForkFET in which nanosheets for a P-type transistor and nanosheets for an N-type transistor are separated by a dielectric wall, so that the N-type transistor and the P-type transistor have a closer structure. In addition, the integrated circuit may include a bipolar junction transistor, as well as FETs, such as a complementary field effect transistors (CFET), a negative capacitance field effect transistor (NCFET), and a carbon nanotube (CNT) FET.

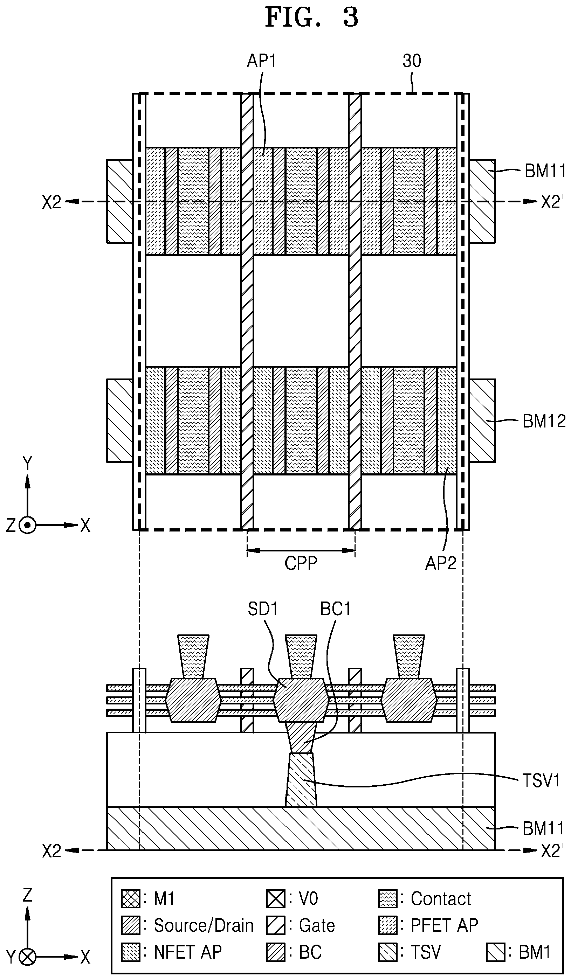

FIG. 3 is a diagram illustrating an example of a layout of an integrated circuit. For example, FIG. 3 illustrates a plan view of a layout of a cell 30 included in an integrated circuit and a cross-sectional view of the layout of the cell 30 taken along line X2-X2'. For convenience of illustration, FIG. 3 illustrates the first backside pattern BM11 and the second backside pattern BM12 of the first backside wiring layer BM1 extending outside of the cell 30.

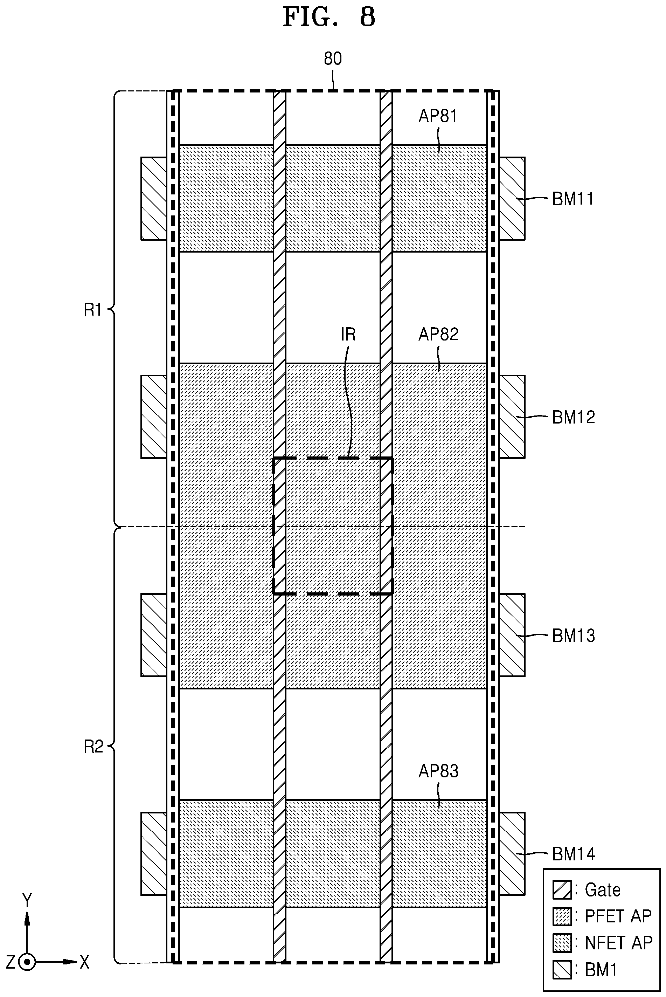

The integrated circuit may include cells. A cell is a unit of layout included in the integrated circuit and may be referred to as a standard cell. A cell may include a transistor and may be designed to perform a predefined function. In the integrated circuit, cells may be arranged in rows. For example, cells may be arranged and aligned in a plurality of rows extending in the X-axis direction. A cell disposed in one row, such as the cell 30 of FIG. 3, may be referred to as a single height cell, and a cell arranged in two or more consecutive rows, such as a cell 80 of FIG. 8, may be referred to as a multi-height cell.

Referring to FIG. 3, the cell 30 may include a PFET active pattern AP1 and an NFET active pattern AP2 extending in the X-axis direction. The PFET active pattern AP1 may form a PFET with a gate electrode extending in the Y-axis direction, and the NFET active pattern AP2 may form an NFET with a gate electrode extending in the Y-axis direction. The gate electrodes may extend parallel to each other in the Y-axis direction with a pitch CPP. As illustrated in FIG. 3, a dummy gate, instead of a gate electrode, may extend in the Y-axis direction along a boundary of a cell. The backside pattern may extend below the active pattern. For example, as illustrated in FIG. 3, the first backside pattern BM11 may extend in the X-axis direction below the PFET active pattern AP1, and the second backside pattern BM12 may extend in the X-axis direction below the NFET active pattern AP2. That is, the first backside pattern BM11 may overlap the PFET active pattern AP1 in the Z-axis direction (i.e., a vertical direction), and the second backside pattern BM12 may overlap the NFET active pattern AP2 in the Z-axis direction.

As illustrated in FIG. 3, the first through-silicon via TSV1 and the first backside contact BC1 may be located between the first source/drain SD1 and the first backside pattern BM11. In some implementations, a positive supply voltage may be applied to the first backside pattern BM11, and the PFETs may receive the positive supply voltage from the first backside pattern BM11. In some implementations, a negative supply voltage may be applied to the second backside pattern BM12, and the NFETs may receive the negative supply voltage from the second backside pattern BM12. The voltages described herein may be applied by one or more voltage generation circuits and/or one or more power gating circuits (e.g. one or more power gating cells). As described above with reference to FIG. 1, inspection of a junction of a transistor may be difficult due to the first backside pattern BM11 and the second backside pattern BM12. Examples of cells including a structure that provides inspection of the junction of the transistor while providing the same function and performance as the cell 30 of FIG. 3 are described below with reference to the drawings.

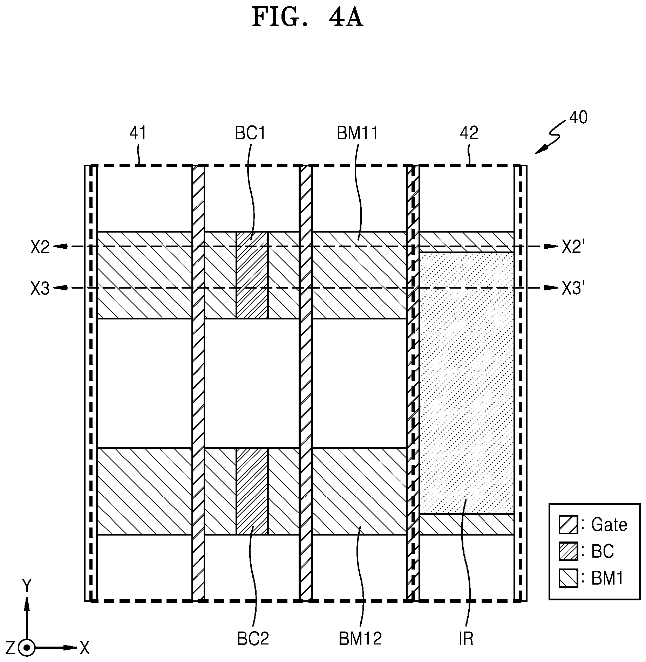

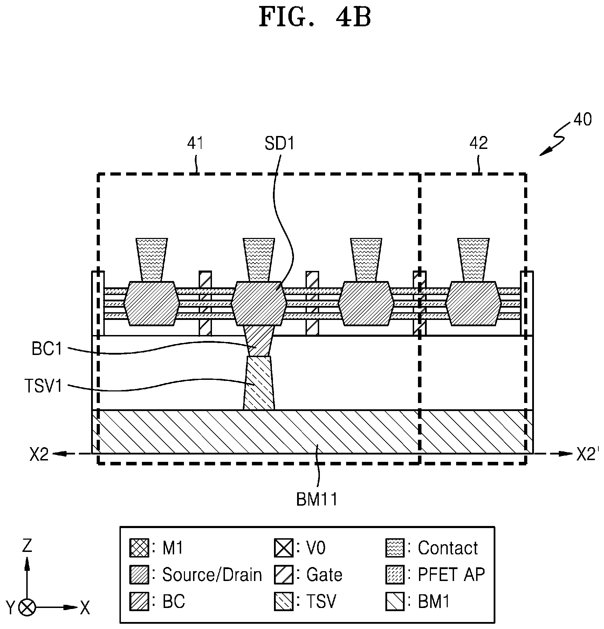

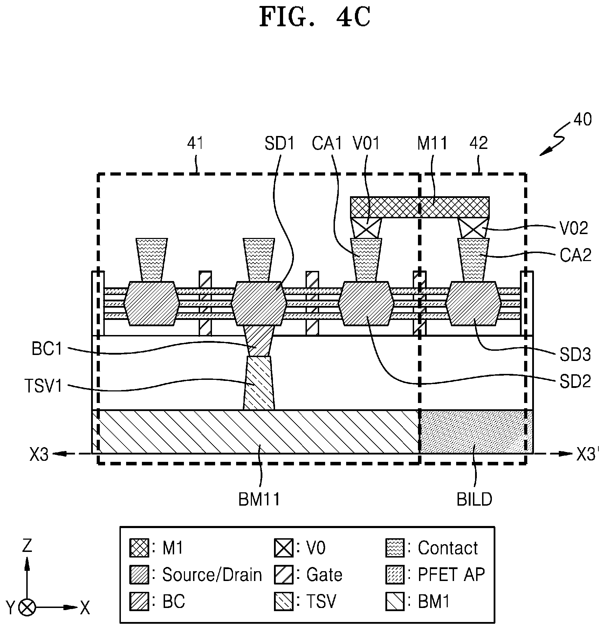

FIGS. 4A, 4B, and 4C are drawings illustrating an example of the layout of an integrated circuit. For example, FIG. 4A is a plan view illustrating the layout of a cell 40, FIG. 4B is a cross-sectional view illustrating the layout of the cell 40 taken along line X2-X2', and FIG. 4C is a cross-sectional view illustrating the layout of the cell 40 taken along line X3-X3'. For convenience of illustration, only the gate electrode, backside contact, and backside pattern are shown in FIG. 4A. In the description with reference to FIGS. 4A to 4C, the same descriptions as those given above with reference to the drawings are omitted.

Referring to FIG. 4A, the cell 40 may include a cell region 41 and a dummy region 42. The cell region 41 may have the same structure as the cell 30 of FIG. 3, and accordingly, the cell 40 of FIG. 4A may provide the same function and performance as the cell 30 of FIG. 3. The dummy region 42 may include an inspection region IR, and the patterns of the first backside wiring layer BM1 may be removed from (e.g. may not be present within) the inspection region IR. The patterns of the backside wiring layer BM1 may be absent from the inspection region IR. The patterns of the backside wiring layer BM1 may not extend into the inspection region IR. For example, as illustrated in FIG. 4A, the first backside pattern BM11 and the second backside pattern BM12 may extend in the X-axis direction and removed from (e.g. may be absent from) the inspection region IR extending in the Y-axis direction. Accordingly, each of the first backside pattern BM11 and the second backside pattern BM12 may have a reduced width (a length in the Y-axis direction) in the dummy region 42. As described above with reference to the drawings, the first backside pattern BM11 and the second backside pattern BM12 may overlap the active patterns in the vertical direction. The inspection region IR may also include a portion vertically overlapping the active patterns, and thus, the junction of the transistor may be inspected through the inspection region IR from which the first backside pattern BM11 and the second backside pattern BM12 have been removed. The first backside contact BC1 and the second backside contact BC2 may be respectively located over the first backside pattern BM11 and the second backside pattern BM12.

Referring to FIG. 4B, the first backside pattern BM11 may extend in the X-axis direction and be connected to the first source/drain SD1 through the first through-silicon via TSV1 and the first backside contact BC1. Unlike that described below with reference to FIG. 4C, the first backside pattern BM11 may be continuous between boundaries of the cells 40 facing in the X-axis direction along the line X2-X2'.

Referring to FIG. 4C, the first backside pattern BM11 may extend in the X-axis direction and be connected to the first source/drain SD1 through the first through-silicon via TSV1 and the first backside contact BC1. As described above with reference to FIG. 4A, the first backside pattern BM11 may be removed from the inspection region IR, and the backside interlayer dielectric BILD may be inserted (e.g. may be present) between the first backside pattern BM11 and the boundary of the cell 40, as shown in FIG. 4C.

The cell 40 may include a structure for biasing a transistor added by the dummy region 42. For example, as illustrated in FIG. 4C, the second source/drain SD2 may be connected to the third source/drain SD3 through the first contact CA1 (e.g. a first source/drain contact), the first via V01, the first frontside pattern M11, a second via V02, and a second contact CA2 (e.g. a second source/drain contact). The first frontside pattern M11 may extend in the X-axis direction. The first frontside pattern M11 may be located in a first frontside wiring layer M1. The first frontside wiring layer M1 may be located on an opposite side (e.g. the upper side, or front side) of the substrate SUB to the side (e.g. the lower side, or back side) of the substrate SUB upon which the first backside wiring layer BM1 is located. In light of the above, the third source/drain SD3 included in the dummy region 42 may be biased to a potential of the second source/drain SD2 and may not affect the operation of the cell 40.

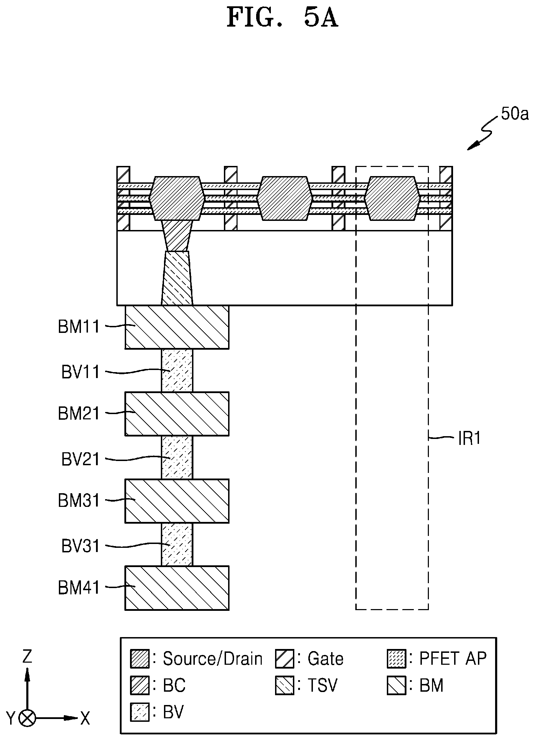

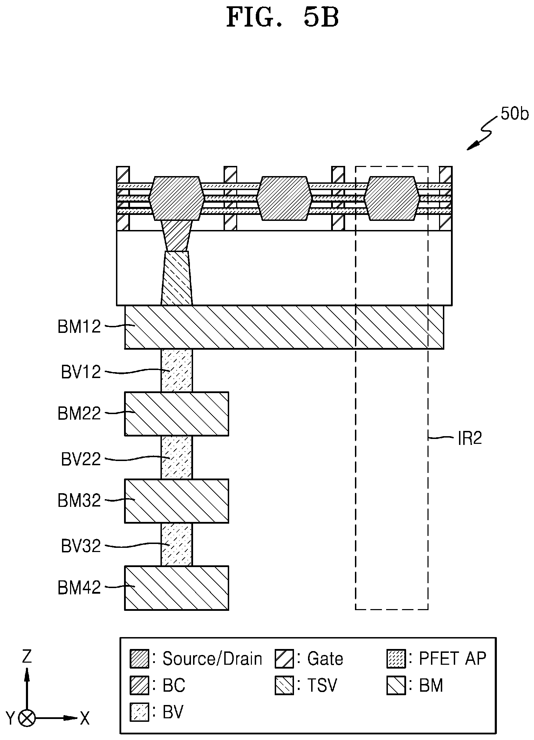

FIGS. 5A and 5B are drawings illustrating examples of layouts 50a and 50b of integrated circuits. For example, FIGS. 5A and 5B show examples of cross-sections of the layouts 50a and 50b. Hereinafter, in the descriptions with reference to FIGS. 5A and 5B, the same descriptions as those given above with reference to the drawings are omitted. In some implementations, unlike those illustrated in FIGS. 5A and 5B, the integrated circuits may include backside patterns formed on less than four or more than four backside wiring layers, respectively.

Referring to FIG. 5A, the layout 50a may include backside patterns extending in a plurality of backside wiring layers and may include backside vias between the backside patterns. For example, as illustrated in FIG. 5A, first to fourth backside patterns BM11 to BM41 may extend in first to fourth backside wiring layers, respectively, and first to third backside vias BV11 to BV31 may be arranged between the first to fourth backside patterns BM11 to BM41, respectively. In some implementations, all backside patterns and backside vias may be removed from the inspection region. For example, as illustrated in FIG. 5A, the backside patterns and backside vias of the first to fourth backside wiring layers may be removed from (e.g. may be absent from) the first inspection region IR1. Accordingly, the active pattern, source/drain and/or gate electrodes may not be blocked by the pattern of the (e.g. any) backside wiring layer but be exposed to a laser from a backside of the layout 50a. That is, the laser may be irradiated in the +Z-axis direction to the first inspection region IR1, and the laser may reach the junction. For instance, in certain implementations, in each backside wiring layer, backside patterns in the backside wiring layer are absent from the inspection region IR2 (e.g. in any backside wiring layer, there are no backside patterns present within the inspection region IR2).

Referring to FIG. 5B, the layout 50b may include backside patterns extending in a plurality of backside wiring layers and may include backside vias between the backside patterns. For example, as illustrated in FIG. 5B, first to fourth backside patterns BM12 to BM42 may extend in first to fourth backside wiring layers, respectively, and first to third backside vias BV12 to BV32 may be disposed between first to fourth backside patterns BM12 to BM42, respectively. In some implementations, at least one backside pattern may be present in the inspection region. For example, as illustrated in FIG. 5B, the second to fourth backside patterns BM22 to BM42 of the second to fourth backside wiring layers may be removed (e.g. may be absent) from the second inspection region IR2, while the first backside pattern BM12 of the first backside wiring layer may also be present in the second inspection region IR2. In some implementations, a laser used in OFI may reach the joint despite one or more backside patterns, and thus at least one backside pattern that does not block the laser may be present in the second inspection region IR2. In some implementations, unlike that illustrated in FIG. 5B, the second backside pattern BM22 of the second backside wiring layer may be additionally present in the second inspection region IR2. For instance, in certain implementations, one or more backside patterns in one or more backside wiring layers may be present within the inspection region IR2, provided that backside patterns are absent from the inspection region IR2 in at least one backside wiring layer (e.g. provided in at least one backside wiring layer there are no backside patterns present within the inspection region IR2).

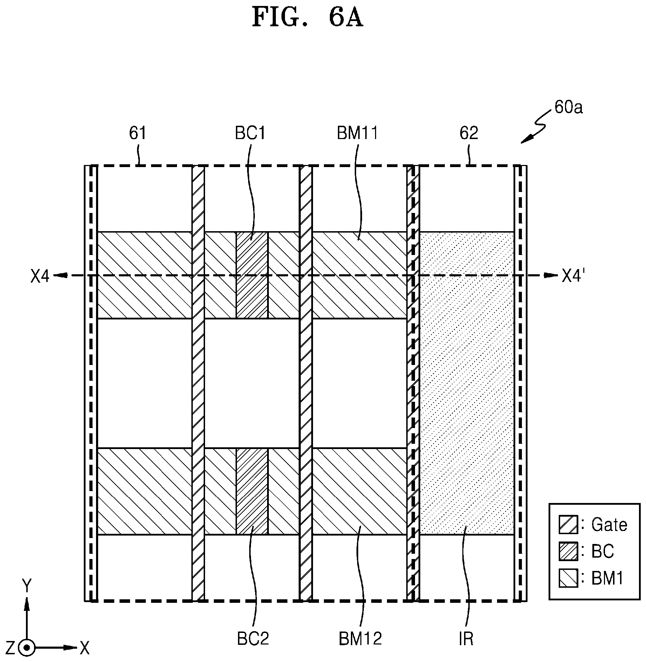

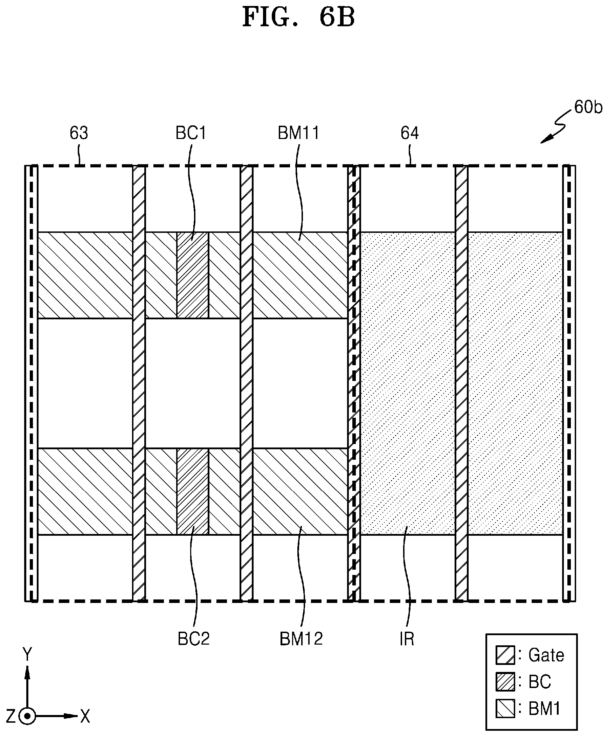

FIGS. 6A and 6B are drawings illustrating examples of layouts of integrated circuits. For example, FIGS. 6A and 6B illustrate examples of the layouts of cells 60a and 60b included in an integrated circuit. For convenience of illustration, only the gate electrode, backside contact, and backside pattern are shown in FIGS. 6A and 6B. In the descriptions with reference to FIGS. 6A and 6B, the same descriptions as those given above with reference to the drawings are omitted.

Referring to FIG. 6A, the cell 60a may include a cell region 61 and a dummy region 62. The cell region 61 may have the same structure as the cell 30 of FIG. 3, and accordingly, the cell 60a of FIG. 6A may provide the same function and performance as the cell 30 of FIG. 3. The dummy region 62 may include the inspection region IR, and the patterns of the first backside wiring layer BM1 may be removed (e.g. may be absent) from the inspection region IR. For example, as illustrated in FIG. 6A, the first backside pattern BM11 and the second backside pattern BM12 may extend in the X-axis direction and be removed from (e.g. may be absent from and/or may not extend into) the inspection region IR extending in the Y-axis direction. Unlike the cell 40 of FIG. 4A, the first backside pattern BM11 and the second backside pattern BM12 may be terminated by the inspection region IR. As illustrated in FIG. 6A, the inspection region IR may interface with a boundary of the cell 60a extending in the Y-axis direction, and accordingly, the first backside pattern BM11 and the second backside pattern BM12 may be shortened by the inspection region IR. In some implementations, a cross-section of the layout of the cell 60a taken along line X4-X4' may be identical to or similar to that in FIG. 4C. The first backside contact BC1 and the second backside contact BC2 may be disposed over the first backside pattern BM11 and the second backside pattern BM12, respectively.

Referring to FIG. 6B, the cell 60b may include a cell region 63 and a dummy region 64. The cell region 63 may have the same structure as the cell 30 of FIG. 3, and accordingly, the cell 60b of FIG. 6B may provide the same function and performance as the cell 30 of FIG. 3. The dummy region 64 may include the inspection region IR, and the patterns of the first backside wiring layer BM1 may be removed (e.g. may be absent) from the inspection region IR. For example, as illustrated in FIG. 6B, the first backside pattern BM11 and the second backside pattern BM12 may extend in the X-axis direction and removed from (e.g. may be absent from and/or may not extend into) the inspection region IR extending in the Y-axis direction. As described above with reference to FIG. 6A, the first backside pattern BM11 and the second backside pattern BM12 may be terminated by the inspection region IR. The first backside contact BC1 and the second backside contact BC2 may be disposed over the first backside pattern BM11 and the second backside pattern BM12, respectively.

In some implementations, the inspection region IR may have a width corresponding to a pitch (i.e., the CPP) of the gate electrode or a width corresponding to the multiple of the pitch (e.g. in the X-axis direction) of the gate electrodes. For example, as described above with reference to FIGS. 4A and 6A, the inspection region IR may have a width corresponding to the pitch between the gate electrode and the dummy gate adjacent to each other (e.g. in the X-axis direction). The pitch between the gate electrode and the dummy gate adjacent to each other may be equal to the pitch between gate electrodes (e.g. between adjacent gate electrodes). Alternatively, as illustrated in FIG. 6B, the inspection region IR may have a width corresponding to twice the pitch of the gate electrodes (e.g. in the X-axis direction).

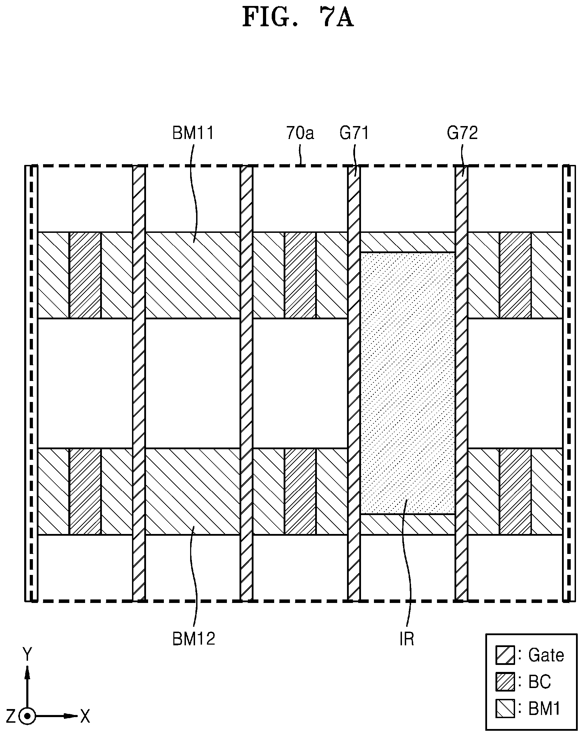

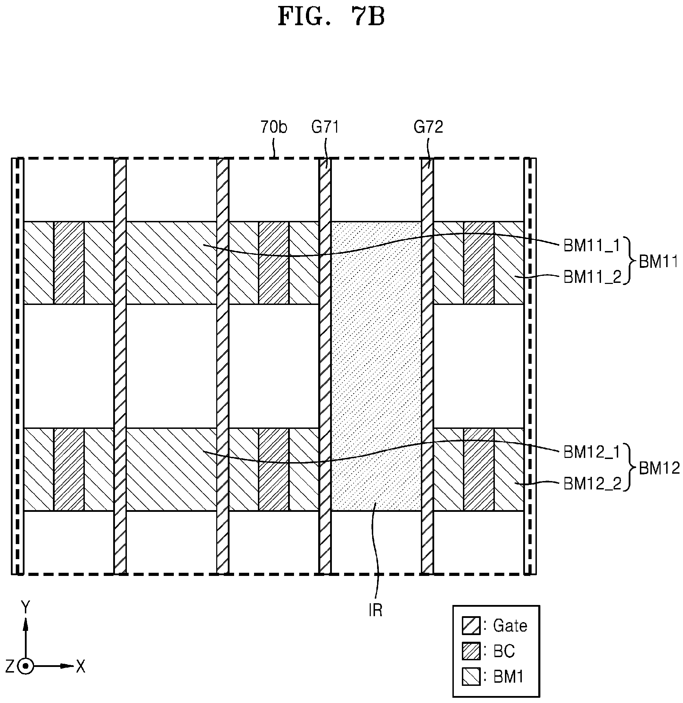

FIGS. 7A and 7B are drawings illustrating examples of layouts of integrated circuits. For example, FIGS. 7A and 7B show examples of layouts of cells 70a and 70b included in an integrated circuit. For convenience of illustration, only the gate electrode, the backside contact, and the backside pattern are shown in FIGS. 7A and 7B. As described below with reference to FIGS. 7a and 7b, the inspection region IR may exist within the boundary of the cell. In the description of FIGS. 7A and 7B, the same descriptions as those given above with reference to the drawings are omitted.

Referring to FIG. 7A, the cell 70a may include the first backside pattern BM11 and the second backside pattern BM12 extending in the X-axis direction. The inspection region IR may extend in the Y-axis direction between the first gate electrode G71 and the second gate electrode G72, and a portion of each of the first backside pattern BM11 and the second backside pattern BM12 may be removed (e.g. may not be present within the inspection region IR). Accordingly, each of the first backside pattern BM11 and the second backside pattern BM12 may be continuous between boundaries of the cells 70a facing each other in the X-axis direction (or extending in the Y-axis direction), while having a reduced width (i.e., a length in the Y-axis direction) below a region between a first gate electrode G71 and a second gate electrode G72, and the second backside pattern B12 may also have a reduced width below a region between the first gate electrode G71 and the second gate electrode G72.

Referring to FIG. 7B, the cell 70b may include the first backside pattern BM11 and the second backside pattern BM12 extending in the X-axis direction. The inspection region IR may extend in the Y-axis direction between the first gate electrode G71 and the second gate electrode G72 and may divide each of the first backside pattern BM11 and the second backside pattern BM12. For example, the first backside pattern BM11 may be divided into two parts BM11_1 and BM11_2 by the inspection region IR, and the second backside pattern BM12 may also be divided into two parts BM12_1 and BM11_2 by the inspection region IR. Accordingly, the first backside pattern BM11 and the second backside pattern BM12 may be discontinuous between boundaries of the cells 70a facing (or adjacent to) each other in the X-axis direction (or extending in the Y-axis direction).

FIG. 8 is a diagram illustrating an example of the layout of an integrated circuit. For example, FIG. 8 illustrates the layout of a cell 80 included in an integrated circuit. For convenience of illustration, only the gate electrode, the backside contact, and the backside pattern are shown in FIG. 8. In the description with reference to FIG. 8, the same descriptions as those given above with reference to the drawings are omitted.

Referring to FIG. 8, the cell 80 may be a multi-height cell and may be continuous in a first row R1 and a second row R2. As described above with reference to the drawings, a single height cell may include a PFET active pattern and an NFET active pattern, and to this end, the PFET active pattern and the NFET active pattern may extend in the X-axis direction in one row extending in the X-axis direction. The backside patterns of the first backside wiring layer BM1 may extend below the active pattern. For example, as illustrated in FIG. 8, in the first row R1, the first backside pattern BM11 and the second backside pattern BM12 may extend in the X-axis direction, and in the second row R2, the third backside pattern BM13 and the fourth backside pattern BM14 may extend in the X-axis direction. Each row may include two backside patterns separated from each other in the Y-axis direction.

As described above with reference to FIG. 2C, when the width of the active pattern, i.e., the nanosheet, in the MBCFET 20c, extends, the width of the channel may extend, and thus the current driving capability of the transistor may increase. For cells with high current driving capability, active patterns extending in different rows may be merged. For example, as illustrated in FIG. 8, a NFET active pattern AP81 may extend in the first row R1, and the NFET active pattern AP83 may extend in the second row R2. The PFET active pattern AP82 may be formed by merging a PFET active pattern extending in the first row R1 and a PFET active pattern extending in the second row R2. Accordingly, the PFET active pattern AP82 may have an extended width (i.e., a length in the Y-axis direction), and the cell 80 may include a PFET having a high (e.g. increased) current driving capability (e.g. relative to non-merged active patterns).

In some implementations, the inspection region IRmay overlap the extended active pattern. For example, as illustrated in FIG. 8, the inspection region IR may overlap the PFET active pattern AP82 in the Z-axis direction, and the backside pattern may be removed (e.g. may be absent) from the inspection region IR. In some implementations, as illustrated in FIG. 8, when the inspection region IR is between the second backside pattern BM12 and the third backside pattern BM13, the inspection region IR may be provided without removing the patterns of the first backside wiring layer BM1 (e.g. without narrowing or terminating the patterns in the backside wiring layer BM1).

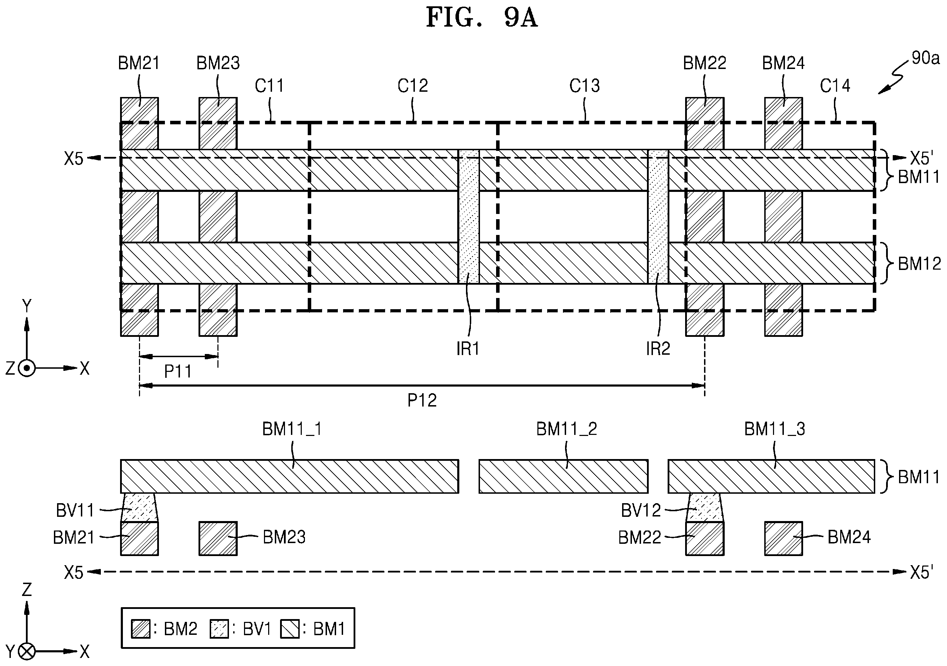

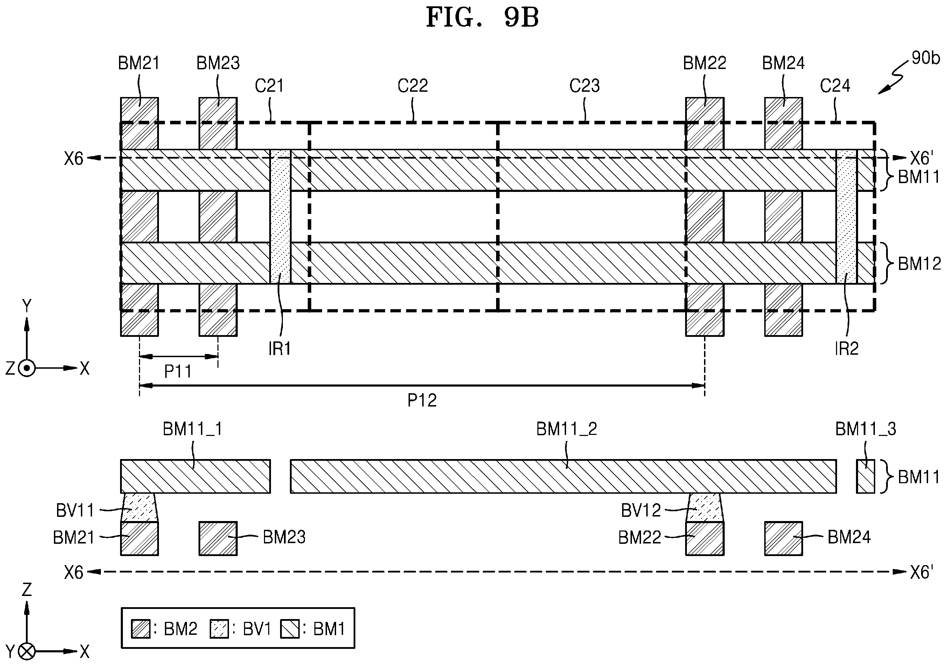

FIGS. 9A and 9B are drawings illustrating examples of layouts of integrated circuits. For example, FIG. 9A illustrates a plan view of a layout 90a and a cross-sectional view of the layout 90a taken along line X5-X5', and FIG. 9B illustrates a plan view of a layout 90b and a cross-sectional view of the layout 90b taken along line X6-X6'. For convenience of illustration, FIGS. 9A and 9B illustrate only the first backside wiring layer BM1, the second backside wiring layer BM2, and the first backside via layer VB1 between the first backside wiring layer BM1 and the second backside wiring layer BM2. In the description of FIGS. 9A and 9B, the same descriptions as those given above with reference to the drawings are omitted.

Referring to FIG. 9A, the layout 90a may include first to fourth cells C11 to C14 arranged in the same row. In some implementations, the integrated circuit may include a backside power delivery network. For example, as illustrated in FIG. 9A, in the first backside wiring layer BM1, the first backside pattern BM11 may extend in the X-axis direction to provide a positive supply voltage, and the second backside pattern BM12 may extend in the X-axis direction to provide a negative supply voltage. In addition, in the second backside wiring layer BM2, the third backside pattern BM21 and the fourth backside pattern BM22 may extend in the Y-axis direction to provide a positive supply voltage, and the fifth backside pattern BM23 and the sixth backside pattern BM24 may extend in the Y-axis direction to provide a negative supply voltage. In some implementations, as illustrated in FIG. 9A, a pitch P11 between the third backside pattern BM21 providing a positive supply voltage and the fifth backside pattern BM23 providing a negative supply voltage may be less than a pitch P12 between the third backside pattern BM21 providing a positive supply voltage and the fourth backside pattern BM22 (e.g. also providing a positive supply voltage). As illustrated in FIG. 9A, the first backside pattern BM11 may be connected to the third backside pattern BM21 through the first backside via BV11 and may be connected to the fourth backside pattern BM22 through the second backside via BV12.

As described above with reference to FIGS. 6A, 6B, and 7B, when the backside pattern of the first backside wiring layer BM1 is divided by an inspection region, a backside pattern of the first backside wiring layer BM1 that is not connected to the backside pattern of the second backside wiring layer BM2 through a via of the first backside via layer BV1 may occur. For example, as illustrated in FIG. 9A, the first backside pattern BM11 may be divided into first to third portions BM11_1 to BM11_3 by a first inspection region IR1 and a second inspection region IR2, and the second portion BM11_2 between the first inspection region IR1 and the second inspection region IR2 may not be connected to the backside patterns of the second backside wiring layer BM2 through any vias of the first backside via layer BV1. Accordingly, increased IR drop may occur in a path through which power is supplied to transistors included in the second cell C12 and/or the third cell C13.

Referring to FIG. 9B, the layout 90b may include first to fourth cells C21 to C24 arranged in the same row. In some implementations, the integrated circuit may include a backside power delivery network. For example, as illustrated in FIG. 9B, in the first backside wiring layer BM1, the first backside pattern BM11 may extend in the X-axis direction to provide a positive supply voltage, and the second backside pattern BM12 may extend in the X-axis direction to provide a negative supply voltage. In addition, in the second backside wiring layer BM2, the third backside pattern BM21 and the fourth backside pattern BM22 may extend in the Y-axis direction to provide a positive supply voltage, and the fifth backside pattern BM23 and the sixth backside pattern BM24 may extend in the Y-axis direction to provide a negative supply voltage. In some implementations, as illustrated in FIG. 9B, the pitch P11 between the third backside pattern BM21 providing a positive supply voltage and the fifth backside pattern BM23 providing a negative supply voltage may be less than the pitch P12 between the third backside pattern BM21 providing a positive supply voltage and the fourth backside pattern BM22. As illustrated in FIG. 9B, the first backside pattern BM11 may be connected to the third backside pattern BM21 through the first backside via BV11 and may be connected to the fourth backside pattern BM22 through the second backside via BV12.

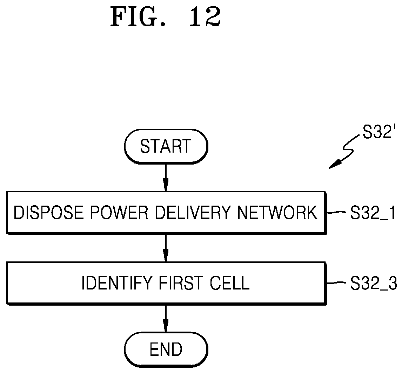

Unlike the layout 90a of FIG. 9A, in the layout 90b of FIG. 9B, the backside patterns of the first backside wiring layer BM1 may be connected to the backside patterns of the second backside wiring layer BM2 through the via of the first via layer BV1. For example, as illustrated in FIG. 9B, each of the first backside pattern BM11 and the second backside pattern BM12 may be divided into three parts by the first inspection region IR1 and the second inspection region IR2, and each of the divided parts may be connected to the backside patterns of the second backside wiring layer BM2 through the vias of the first via layer BV1. For instance, in particular implementations, only one (e.g. no more than one) inspection region IR1 may be positioned between adjacent sets of backside patterns (e.g. providing positive and negative supply voltages). Accordingly, a path through which power is supplied to the transistors included in the first to fourth cells C21 to C24 may have a low IR drop. An example of the operation of disposing the inspection region to provide a low IR drop is described below with reference to FIG. 12.

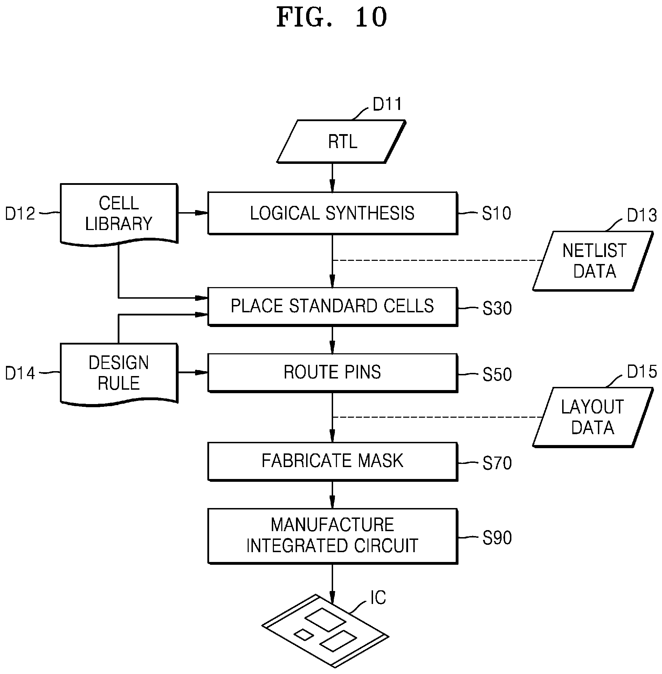

FIG. 10 is a flowchart illustrating an example of a method of manufacturing an integrated circuit IC. In detail, the flowchart of FIG. 10 illustrates an example of a method of manufacturing an integrated circuit IC including cells. As illustrated in FIG. 10, a method of manufacturing an integrated circuit IC may include a plurality of operations (S10, S30, S50, S70, and S90).

Cell library (or a standard cell library) D12 may include information on cells, such as information on functions, characteristics, layouts, etc. In some implementations, the cell library D12 may define different layouts for the same cell. For example, the cell library D12 may define the layouts of FIG. 3, FIG. 4A, FIG. 6A and FIG. 6B for one cell. As described above with reference to the drawings, the layouts of FIGS. 3, 4A, 6A, and 6B may correspond to cells providing the same function and performance.

Design rule D14 may include requirements that the layout of an integrated circuit IC has to follow. For example, the design rule D14 may include requirements for the space between patterns in the same layer, a minimum width of a pattern, a routing direction in a wiring layer, etc. In some implementations, the design rule D14 may define a minimum length of an inspection region, a minimum width of the inspection region, a minimum area of the inspection region, etc.

In operation S10, a logical synthesis operation for generating netlist data D13 from register-transfer level (RTL) data D11 may be performed. For example, a semiconductor design tool (e.g., a logic synthesis tool) may perform logic synthesis by referencing the cell library D12 from RTL data D11 written as a hardware description language (HDL), such as a very high speed integrated circuit (VHSIC) hardware description language (VHDL) and Verilog, thereby generating netlist data D13 including a bitstream or netlist. The netlist data D13 may correspond to input of place and routing described below. Herein, the netlist data D13 may be referred to as input data.

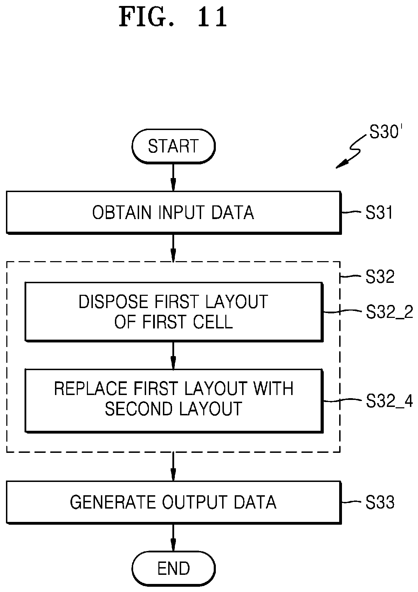

In operation S30, cells may be arranged. For example, a semiconductor design tool (e.g., a P&R tool) may place cells used in the netlist data D13 by referring to the cell library D12 and design rule D14. In some implementations, the semiconductor design tool may place power gating cells and place backside patterns in the backside wiring layer. Examples of operation S30 are described below with reference to FIG. 11.

In operation S50, pins of the cells may be routed. For example, a semiconductor design tool may generate interconnections that electrically connect the output pins to input pins of disposed functional cells. In addition, the semiconductor design tool may generate interconnections connected to nodes to which a positive supply voltage is applied or nodes to which a negative supply voltage is applied to provide power to the functional cells. The interconnection may include a pattern of vias in the via layer and/or a wiring layer. The semiconductor design tool may generate layout data D15 that defines the disposed cells and the generated interconnections. The layout data D15 may have a format, such as Graphic Design System II (GDSII), and may include geometric information of cells and interconnections. The semiconductor design tool may refer to the design rule D14 while routing the pins of cells. The semiconductor design tool may not place backside patterns in the inspection region, thereby enabling OFI through the inspection region. The layout data D15 may correspond to the output of arrangement and routing. In some implementations, operations S30 and S50 may be repeated. Operation S50 alone, or operations S30 and S50 collectively, may be referred to as a method of designing an integrated circuit.

In operation S70, an operation of fabricating a mask may be performed. For example, optical proximity correction (OPC) to correct a distortion phenomenon, such as refraction caused by the characteristics of light in photolithography may be applied to the layout data D15. Patterns on a mask may be defined to form patterns arranged in a plurality of layers based on data to which OPC is applied, and at least one mask (or photomask) may be manufactured to form the patterns of each of the layers. In some implementations, the layout of the integrated circuit IC may be limitedly modified in operation S70, and the limited modification of the integrated circuit IC in operation S70 may be referred to as design polishing as a post-processing to optimize the structure of the integrated circuit IC.

In operation S90, an operation of manufacturing the integrated circuit IC may be performed. For example, the integrated circuit IC may be manufactured by patterning a plurality of layers using at least one mask manufactured in operation S70. The front-end-of-line (FEOL) may include, for example, operations of planarizing and cleaning a wafer, forming a trench, forming a well, forming a gate electrode, and forming a source and drain. By means of FEOL, individual devices, such as transistors, capacitors, resistors, etc., may be formed on the substrate. The term FEOL may refer to the method of manufacturing the structures (e.g. devices) on the front side of the substrate. The term FEOL may also refer to the structures (e.g. devices) on the front side of the substrate. In addition, a back-end-of-line (BEOL) may include operations, such as silicidating gate, source and drain regions, adding a dielectric, planarizing, forming a hole, adding a metal layer, forming a via, forming a passivation layer, etc. By BEOL, individual devices, such as transistors, capacitors, resistors, etc. may be interconnected. The term BEOL may refer to the method of manufacturing the structures (e.g. devices) on the back side of the substrate. The term FEOL may also refer to the structures (e.g. devices) on the back side of the substrate. In some implementations, a middle-of-line (MOL) may be performed between the FEOL and BEOL, and contacts may be formed on the individual devices. The term MEOL may refer to the method of manufacturing the structures (e.g. devices) between the FEOL and BEOL. The term MEOL may also refer to the structures (e.g. devices) between the FEOL and BEOL. Thereafter, the integrated circuit IC may be packaged into a semiconductor package and used as a component in a variety of applications.

FIG. 11 is a flowchart illustrating an example of a method of designing an integrated circuit. For example, the flowchart of FIG. 11 illustrates an example of operation S30 of FIG. 10. As described above with reference to FIG. 10, cells may be arranged in operation S30' of FIG. 11. As illustrated in FIG. 11, operation S30' may include a plurality of operations (S31 to S33). Hereinafter, FIG. 11 is described with reference to FIG. 10.

Referring to FIG. 11, input data may be obtained in operation S31. For example, the semiconductor design tool may obtain netlist data D13 as input data. As described above with reference to FIG. 10, the netlist data D13 may define cells included in the integrated circuit.

In operation S32, cells may be placed. For example, the semiconductor design tool may place cells defined in the netlist data D13 by referring to the cell library D12 and design rule D14. As illustrated in FIG. 11, operation S32 may include operations S32_2 and S32_4. In operation S32_2, a first layout of a first cell may be disposed. Herein, the first layout may refer to a layout that does not include an inspection region, as in FIG. 3. The semiconductor design tool may select a cell to be disposed from the netlist data D13, identify the first layout corresponding to the selected cell from the cell library D12, and dispose the identified first layout. In operation S32_4, the first layout may be replaced with a second layout. Herein, the second layout may refer to the layout including an inspection region, such as FIGS. 4A, 6A, and 6B. Accordingly, an inspection region for OFI may be generated by replacing the first layout with the second layout including an inspection region.

In operation S33, output data may be generated. For example, the output data may define the arranged cells. The output data may be provided in operation S50 of FIG. 10.

FIG. 12 is a flowchart illustrating an example of a method of designing an integrated circuit. For example, the flowchart of FIG. 12 illustrates an example of operation S32 of FIG. 11. As described above with reference to FIG. 11, cells may be arranged in operation S32' of FIG. 12. As illustrated in FIG. 12, operation S32' may include a plurality of operations S32_1 and S32_3.

In operation S32_1, a power delivery network may be disposed. In some implementations, the semiconductor design tool may dispose a backside power delivery network. Accordingly, as described above with reference to FIGS. 9A and 9B, backside patterns extending in the Y-axis direction may be disposed in the second backside wiring layer BM2.

In operation S32_3, a first cell may be identified. As described above with reference to FIG. 11, the first cell may refer to a cell that is replaced with the second layout after the first layout is disposed. In some implementations, the semiconductor design tool may identify the first cell based on the backside patterns of the second backside wiring layer disposed in operation S32_1. For example, the semiconductor design tool may identify the first cell that vertically overlaps at least one of the backside patterns of the second backside wiring layer disposed in operation S32_1. As described above with reference to FIG. 9A, if a cell (e.g., C12 and C13 of FIG. 9A) that does not vertically overlap the backside pattern of the second backside wiring layer includes an inspection region, increased IR drop may occur. Accordingly, as described above with reference to FIG. 9B, the semiconductor design tool may identify cells (e.g., C21 and C24 of FIG. 9B) that vertically overlap the backside pattern of the second backside wiring layer and replace the first layout of the identified cell with the second layout. Accordingly, an increase in IR drop may be prevented.

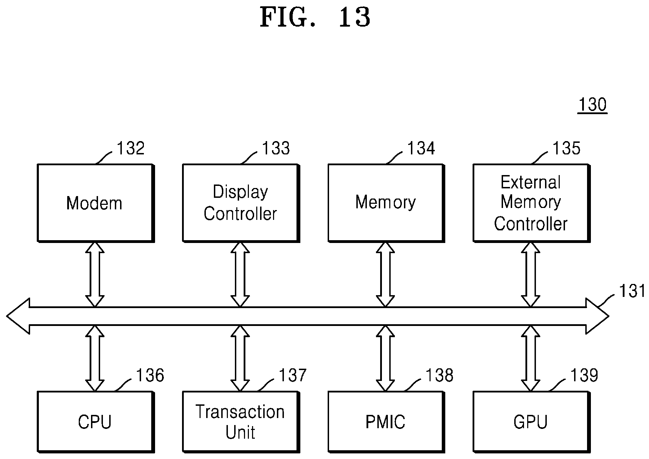

FIG. 13 is a block diagram illustrating an example of a system-on-chip (SoC) 130. The SoC 130 is a semiconductor device that may include an integrated circuit according to an implementation. The SoC 130 is a device that implements complex blocks, such as intellectual property (IP) that performs various functions, in a single chip. The SoC 130 may be designed by a method of designing an integrated circuit according to implementations, and thus the SoC 130 may provide the designed performance and functions with high reliability. Referring to FIG. 13, the SoC 130 may include a modem 132, a display controller 133, a memory 134, an external memory controller 135, a central processing unit (CPU) 136, a transaction unit 137, a PMIC 138, and a graphics processing unit (GPU) 139, and each functional block of the SoC 130 may communicate with each other through a system bus 131.

The CPU 136 capable of controlling the operation of the SoC 130 at the highest level may control the operation of other functional blocks 132 to 139. The modem 132 may demodulate a signal received from outside the SoC 130 or modulate a signal generated inside the SoC 130 and transmit the signal to the outside. The external memory controller 135 may control operations of transmitting and receiving data from an external memory device connected to the SoC 130. For example, programs and/or data stored in an external memory device may be provided to the CPU 136 or GPU 139 under control by the external memory controller 135. The GPU 139 may execute program instructions related to graphics processing. The GPU 139 may receive graphic data through the external memory controller 135 and may transmit graphic data processed by the GPU 139 to the outside of the SoC 130 through the external memory controller 135. The transaction unit 137 may monitor data transactions of each functional block, and the PMIC 138 may control power supplied to each functional block under control by the transaction unit 137. The display controller 133 may control a display (or a display device) outside the SoC 130 to transmit data generated within the SoC 130 to the display. The memory 134 may include nonvolatile memory, such as electrically erasable programmable read-only memory (EEPROM), flash memory, etc. or may include volatile memory, such as dynamic random access memory (DRAM), static random access memory (SRAM), etc.

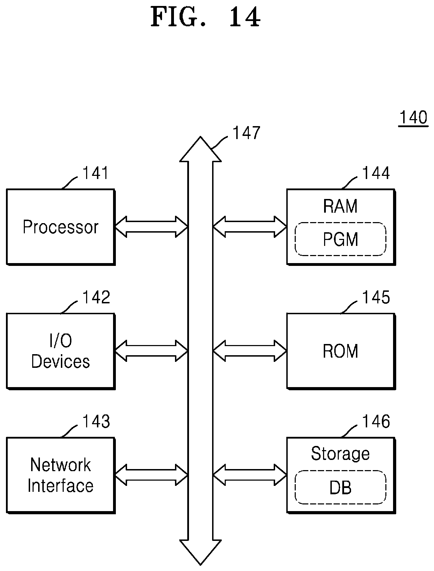

FIG. 14 is a block diagram illustrating an example of a computing system 140 including a memory storing a program. A method of designing an integrated circuit according to implementations, for example, at least some of the operations of the flowchart described above, may be performed in the computing system (or computer) 140.

The computing system 140 may be a stationary computing system, such as a desktop computer, workstation, server, or the like or may be a portable computing system, such as a laptop computer. As illustrated in FIG. 14, the computing system 140 may include a processor 141, input/output (I/O) devices 142, a network interface 143, a random-access memory (RAM) 144, a read only memory (ROM) 145, and a storage 146. The processor 141, the I/O devices 142, the network interface 143, the RAM 144, the ROM 145, and the storage 146 may be connected to a bus 147 and communicate with each other through the bus 147.

The processor 141 may be referred to as a processing unit and may include at least one core capable of executing any instruction set (e.g., Intel Architecture-32 (IA-32)), 64-bit extended IA-32, x86-64, PowerPC, Sparc, MIPS, ARM, IA-64, etc.), such as a microprocessor, an application processor (AP), a digital signal processor (DSP), or a GPU. For example, the processor 141 may access memory, i.e., the RAM 144 or ROM 145, through the bus 147 and execute instructions stored in the RAM 144 or ROM 145.

The RAM 144 may store a program PGM or at least a portion thereof for a method of designing an integrated circuit according to an implementation, and the program PGM may cause the processor 141 to perform at least some of the operations included in the method of designing an integrated circuit, for example, the methods of FIG. 11. That is, the program PGM may include a plurality of instructions executable by the processor 141, and the instructions included in the program PGM may cause the processor 141 to perform at least some of the operations included in the flowcharts described above.

The storage 146 may not lose stored data even if power supplied to the computing system 140 is cut off. For example, the storage 146 may include nonvolatile memory devices or may include a storage medium, such as magnetic tape, optical disks, or magnetic disks. In addition, the storage 146 may be removable from the computing system 140. The storage 146 may store the program PGM according to an implementation, and the program PGM or at least a portion thereof may be loaded from the storage 146 into the RAM 144 before the program PGM is executed by the processor 141. Alternatively, the storage 146 may store a file written in a programming language, and the program PGM or at least a portion thereof generated by a compiler or the like from the file may be loaded into the RAM 144. In addition, as illustrated in FIG. 14, the storage 146 may store a database DB, and the database DB may include information necessary for designing an integrated circuit, such as information on designed blocks, the cell library D12 of FIG. 10, and/or design rules D14.

The storage 146 may store data to be processed by the processor 141 or data processed by the processor 141. That is, the processor 141 may generate data by processing data stored in storage 146 according to the program PGM and may also store the generated data in the storage 146. For example, the storage 146 may store the RTL data D11, the netlist data D13 and/or the layout data D15 of FIG. 10.

The I/O devices 142 may include input devices, such as a keyboard, a pointing device, etc. and may include output devices, such as a display device, a printer, etc. For example, the user may trigger execution of the program PGM by the processor 141 through the I/O devices 142, input the RTL data D11 and/or the netlist data D13 of FIG. 10, and check the layout data D15 of FIG. 10.

The network interface 143 may provide access to a network outside the computing system 140. For example, a network may include a plurality of computing systems and communication links, and the communication links may include wired links, optical links, wireless links, or any other form of links.

Methods described herein include methods for designing an integrated circuit. These methods may generate a design of an integrated circuit and may generate (e.g. output) computer executable instructions for controlling one or more manufacturing devices to manufacture the integrated circuit according to the design. Following the design of the integrated circuit, the integrated circuit may be manufactured according to the design.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Embodiments are set out in the following Clauses:
Clause 1. An integrated circuit comprising:
   a plurality of active patterns extending in a first horizontal direction; and
   a plurality of backside patterns extending below the plurality of active patterns,
   wherein the plurality of backside patterns include a first backside pattern, the first backside pattern overlapping a first active pattern among the plurality of active patterns in a vertical direction, the first backside pattern extending in a first backside wiring layer in the first horizontal direction, and
   wherein the first backside pattern is removed from a first inspection region that overlaps the first active pattern and extends in a second horizontal direction.
Clause 2. The integrated circuit of Clause 1, wherein
   the plurality of backside patterns include a second backside pattern, the second backside pattern overlaps a second active pattern in the vertical direction, the second active pattern is adjacent to the first active pattern among the plurality of active patterns, and the second backside pattern extends in the first backside wiring layer in the first horizontal direction, and
   the second backside pattern is removed from the first inspection region that overlaps the second active pattern.
Clause 3. The integrated circuit of Clause 1 or Clause 2, wherein the first inspection region divides the first backside pattern into a first portion and a second portion.
Clause 4. The integrated circuit of Clause 3, wherein
   the plurality of backside patterns include a third backside pattern and a fourth backside pattern,
   the third backside pattern and the fourth backside pattern extend in parallel with each other in the second horizontal direction in a second backside wiring layer below the first backside wiring layer,
   the first portion is connected with the third backside pattern through a first via of a first via layer between the first backside wiring layer and the second backside wiring layer, and
   the second portion is connected with the fourth backside pattern through a second via of the first via layer.
Clause 5. The integrated circuit of any of Clauses 1-4, wherein a width of the first backside pattern is changed by the first inspection region.
Clause 6. The integrated circuit of any of Clause 1-5, comprising:
   a plurality of gate electrodes extending in the second horizontal direction with a first pitch,
   wherein a width of the first inspection region corresponds to the first pitch or a multiple of the first pitch.

While the present disclosure has been shown and described with reference to implementations thereof, it will be understood that various changes in form and details may be made therein without departing from the scope of the following claims.

## Claims

1. An integrated circuit comprising a plurality of cells positioned in a plurality of rows, the plurality of rows extending in a first horizontal direction,
wherein the plurality of cells include a first cell (40) disposed in a first row,
wherein the first cell (40) comprises:
a first active pattern extending in the first horizontal direction, and
a first backside pattern (BM11) overlapping the first active pattern in a vertical direction, the first backside pattern (BM11) extending in the first horizontal direction and being in a first backside wiring layer (BM1) below the first active pattern,
wherein the first backside pattern (BM11) is removed from a first inspection region (IR), and the first inspection region (IR) overlaps the first active pattern and extends in a second horizontal direction.

2. The integrated circuit of claim 1, wherein the first cell (40) comprises:
a second active pattern extending in the first horizontal direction, and
a second backside pattern (BM12) that overlaps the second active pattern in the vertical direction and extends in the first horizontal direction in the first backside wiring layer (BM1), wherein the second backside pattern (BM12) is removed from the first inspection region (IR), and the first inspection region (IR) overlaps the second active pattern.

3. The integrated circuit of claim 1 or claim 2, wherein
the first inspection region (IR) contacts a boundary of the first cell (40), and
the first backside pattern (BM11) ends at the first inspection region (IR).

4. The integrated circuit of claim 1 or claim 2, wherein the first inspection region (IR) divides the first backside pattern (BM11) into a first portion (BM1 1_1) and a second portion (BM11_2).

5. The integrated circuit of claim 4, wherein the plurality of cells include a second cell, and the first cell (40) and the second cell have a same front end of line.

6. The integrated circuit of claim 1 or claim 2, wherein a width of the first backside pattern (BM11) is changed by the first inspection region (IR).

7. The integrated circuit of any preceding claim, wherein the first cell (40) includes:
a first source/drain contact (CA1) overlapping the first active pattern in the vertical direction,
a second source/drain contact (CA2) overlapping the first inspection region (IR), and
a first frontside pattern (M11) electrically connected with the first source/drain contact (CA1) and the second source/drain contact (CA2), the first frontside pattern (M11) extending in a first frontside wiring layer (M1) in the first horizontal direction.

8. The integrated circuit of any preceding claim, wherein
the first cell (40) includes a plurality of gate electrodes (G), the plurality of gate electrodes (G) extending in the second horizontal direction with a first pitch, and
a width of the first inspection region (IR) corresponds to the first pitch or a multiple of the first pitch.

9. The integrated circuit of any preceding claim, wherein the first backside pattern (BM11) is configured to apply a supply voltage to the first cell (40).

10. The integrated circuit of claim 1 comprising:
a plurality of active patterns extending in the first horizontal direction, the plurality of active patterns including the first active pattern; and
a plurality of backside patterns extending below the plurality of active patterns, the plurality of backside patterns including the first backside pattern (BM11).

11. The integrated circuit of claim 10, wherein
the plurality of backside patterns include a second backside pattern (BM12), the second backside pattern (BM12) overlaps a second active pattern in the vertical direction, the second active pattern is adjacent to the first active pattern among the plurality of active patterns, and the second backside pattern (BM12) extends in the first backside wiring layer (BM1) in the first horizontal direction, and
the second backside pattern (BM12) is removed from the first inspection region (IR) that overlaps the second active pattern.

12. The integrated circuit of claim 10 or claim 11, wherein the first inspection region (IR) divides the first backside pattern (BM11) into a first portion (BM11_1) and a second portion (BM11_2).

13. The integrated circuit of claim 12, wherein
the plurality of backside patterns include a third backside pattern (BM21) and a fourth backside pattern (BM23),
the third backside pattern (BM21) and the fourth backside pattern (BM22) extend in parallel with each other in the second horizontal direction in a second backside wiring layer (BM2) below the first backside wiring layer (BM1),
the first portion (BM1 1_1) is connected with the third backside pattern (BM21) through a first via (BV11) of a first via layer (BV1) between the first backside wiring layer (BM1) and the second backside wiring layer (BM2), and
the second portion (BM11_2) is connected with the fourth backside pattern (BM22) through a second via (BV12) of the first via layer (BV1).

14. The integrated circuit of claim 10 or claim 11, wherein a width of the first backside pattern (BM11) is changed by the first inspection region (IR).

15. The integrated circuit of any of claims 10-14, comprising:
a plurality of gate electrodes (G) extending in the second horizontal direction with a first pitch,
wherein a width of the first inspection region (IR) corresponds to the first pitch or a multiple of the first pitch.
